# EUROPEAN PATENT SPECIFICATION

(11) **EP 4 155 746 B1**
(45) Date of publication and mention of the grant of the patent: **21.10.2026**
(21) Application number: 21889561.3
(22) Date of filing: 03.11.2021
(51) Int. Cl.: G01R 31/389, G01R 31/36, G01R 27/02, G01R 27/08, G01R 19/10, G01R 31/396, H01M 10/48, G01R 31/392, H01M 10/42

(54) **BATTERY DIAGNOSING APPARATUS AND METHOD**
BATTERIEDIAGNOSEVORRICHTUNG UND -VERFAHREN
DISPOSITIF ET PROCÉDÉ DE DIAGNOSTIC DE BATTERIE

(30) Priority: 05.11.2020 KR 20200146828
(43) Date of publication of application: 29.03.2023
(73) Proprietor: LG Energy Solution, Ltd., Seoul 07335 (KR)
(72) Inventor: HONG, Sung-Ju, Daejeon 34122 (KR); LEE, Dong-Chun, Daejeon 34122 (KR); CHOI, Geon, Daejeon 34122 (KR); YOON, Seog-Jin, Daejeon 34122 (KR)
(74) Representative: Plasseraud IP
(86) International application number: PCT/KR2021/015825
(87) International publication number: WO 2022/098096

(56) References cited:
- CN-B- 106 356 554
- DE-T5- 112017 001 402
- JP-A- 2005 195 604
- JP-A- 2017 146 194
- KR-A- 20130 013 101
- KR-A- 20180 122 378
- US-B2- 10 746 804

## Description

### TECHNICAL FIELD

The present disclosure relates to a battery diagnosing apparatus and method, and more particularly, to a battery diagnosing apparatus and method capable of diagnosing a state of each battery module based on resistances of a plurality of battery modules.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Since the battery cell has a limited capacity, a battery module in which a plurality of battery cells are connected in series and/or in parallel is mainly used. However, if the number of battery cells included in the battery module increases, an abnormal situation may occur with respect to the battery cells due to a problem in the battery cell itself and/or a connection problem between the battery cells. An example of a battery system can be found for instance in DE 11 2017 001402 T5, describing a battery diagnosis having a resistance measurement module and being based on the selection of target modules that have a resistance higher or lower than two corresponding threshold values.

For example, the connection between the plurality of battery cells may be released, non-uniform degradation may be caused due to accumulation of thermal imbalance according to installation positions of the battery cells, and/or a current concentration phenomenon may occur due to non-uniform degradation.

Therefore, it is required to develop a technology for accurately and quickly diagnosing a state of a battery module and a plurality of battery cells included in the battery module.

### DISCLOSURE

### Technical Problem

The present disclosure is designed to solve the problems of the related art, and therefore the present disclosure is directed to providing a battery diagnosing apparatus and method capable of more accurately diagnosing a state of a battery module.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery diagnosing apparatus according to one aspect of the present disclosure is defined in the appended claims.

A battery pack according to another aspect of the present disclosure is also provided.

A battery diagnosing method according to still another aspect of the present disclosure is provided.

### Advantageous Effects

According to one aspect of the present disclosure, since the state of the battery module is diagnosed according to whether the measured internal resistance belongs to the first resistance section and the second resistance section, the state of the battery module may be diagnosed with a stricter standard. Accordingly, the diagnosis accuracy for the state of the battery diagnosed by the battery diagnosing apparatus may be improved.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a battery diagnosing apparatus according to an embodiment of the present disclosure.
FIG. 2 is a diagram schematically showing a first resistance section according to an embodiment of the present disclosure.
FIG. 3 is a diagram schematically showing a second resistance section according to an embodiment of the present disclosure.
FIG. 4 is a diagram schematically showing an exemplary configuration of a battery pack according to another embodiment of the present disclosure.
FIG. 5 is a diagram schematically showing a battery diagnosing method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, terms such as a control unit described in the specification mean a unit that processes at least one function or operation, which may be implemented as hardware or software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

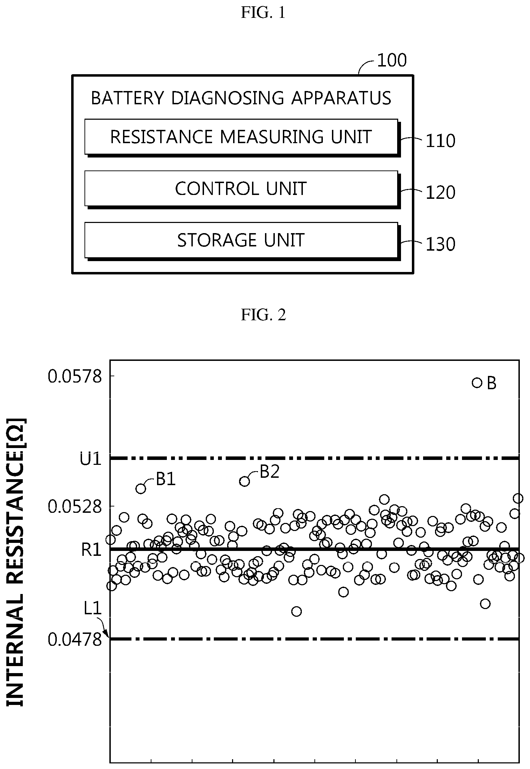

FIG. 1 is a diagram schematically showing a battery diagnosing apparatus 100 according to an embodiment of the present disclosure.

Referring to FIG. 1, the battery diagnosing apparatus 100 according to an embodiment of the present disclosure includes a resistance measuring unit 110 and a control unit 120.

The resistance measuring unit 110 is configured to measure an internal resistance of each of a plurality of battery modules including one or more battery cells.

Here, the battery module may include one or more battery cells connected in series and/or in parallel. In addition, the battery cell means a physically separable one independent cell having a negative electrode terminal and a positive electrode terminal. For example, one pouch-type lithium polymer cell may be regarded as a battery cell.

The resistance measuring unit 110 may measure the resistance of the battery module when charging is started or when discharging is terminated. Preferably, the resistance measuring unit 110 may be configured to measure a voltage of the battery module.

Specifically, the resistance measuring unit 110 may measure the voltage of the battery module at a first time point when charging of the battery module starts, and may measure the voltage of the battery module at a second time point when a predetermined time elapses from the first time point. In addition, the resistance measuring unit 110 may calculate a voltage difference between the voltages of the battery module measured at the first time point and the second time point, respectively. In addition, the resistance measuring unit 110 may calculate the internal resistance of the battery module by using the calculated voltage difference and a charging current for the battery module. Here, the magnitude of the charging current (or discharging current) may be a preset value or a value directly measured by the resistance measuring unit 110. In addition, the resistance measuring unit 110 may receive the magnitude of the charging current (or discharging current) from the outside.

For example, the resistance measuring unit 110 may measure a first voltage of the battery module at the first time point, and measure a second voltage of the battery module at the second time point when 5 seconds have elapsed from the first time point. In addition, the resistance measuring unit 110 may measure the resistance of the battery module based on the difference between the second voltage and the first voltage.

Hereinafter, it is assumed that the battery module may be charged and/or discharged with a constant current.

In this case, the resistance measuring unit 110 may measure the resistance of the battery module through Equation 1 below. [Equation 1] ${DCIR}_{i} = \frac{Δ {V}_{i}}{I}$

Here, DCIR is the resistance [Ω] of the battery module, and I is the charging current [mA] or discharging current [mA] for the battery module. △V is the voltage difference [mV] of the battery module for a predetermined time. i is an index indicating each battery module, and may be 1 or more and n or less. n may be the total number of the plurality of battery modules whose state is to be diagnosed by the battery diagnosing apparatus 100.

For example, the resistance measuring unit 110 may measure the first voltage (V₁) of the battery module at the first time point when charging starts. In addition, the resistance measuring unit 110 may measure the second voltage (V₂) of the battery module at the second time point at which a predetermined time has elapsed from the first time point. The resistance measuring unit 110 calculates "V₂-V₁" to calculate the voltage difference of the battery module between the first time point and the second time point. In this case, since the magnitude of the charging current (I) for the battery module is constant, the resistance measuring unit 110 may measure the resistance (DCIR) of the battery module based on the voltage difference (△V) and the current (I).

The control unit 120 is configured to receive resistance information about the internal resistance of each of the plurality of battery modules from the resistance measuring unit 110.

The control unit 120 and the resistance measuring unit 110 may be connected to be able to communicate with each other. The resistance measuring unit 110 may measure the internal resistance of each of the plurality of battery modules and transmit resistance information about the measured internal resistance to the control unit 120.

The control unit 120 is configured to calculate a first criterion resistance R1 and a resistance deviation for the plurality of battery modules based on the resistance information.

The first criterion resistance R1 is a value calculated by considering all of the internal resistances of the plurality of battery modules, and may be a value representing the internal resistances of the plurality of battery modules. In addition, the resistance deviation may be a value calculated based on the internal resistance of each of the plurality of battery modules and the first criterion resistance R1.

For example, the first criterion resistance R1 is a value representing the internal resistances of the plurality of battery modules, and a median value or an average value may be applied. Preferably, the first criterion resistance R1 may be a median value of the internal resistances of the plurality of battery modules.

The control unit 120 is configured to set a first resistance section based on the calculated first criterion resistance R1 and the calculated resistance deviation.

FIG. 2 is a diagram schematically showing the first resistance section according to an embodiment of the present disclosure. Specifically, FIG. 2 is a diagram showing the internal resistances of the plurality of battery modules B in the form of a graph, and includes a first criterion resistance R1, a first upper limit value U1, and a first lower limit value L1. In FIG. 2, the Y-axis may represent the internal resistance [Ω], and the X-axis may be a serial number of the battery module B. That is, the value of the X-axis is a value independent of the internal resistance, and may be applied without limitation as long as it is a factor that can identify each of the plurality of battery modules B.

Referring to FIG. 2, the first lower limit value L1 and the first upper limit value U1 may be set symmetrically with respect to the first criterion resistance R1. The resistance section from the first lower limit value L1 to the first upper limit value U1 may be set as the first resistance section. In addition, in the embodiment of FIG. 2, all of the internal resistances of the plurality of battery modules B may be included in the first resistance section.

The control unit 120 is configured to select a part of the plurality of battery modules B as a target module based on the resistance information.

For example, the control unit 120 may select two or more battery modules B among the plurality of battery modules B as a target module. Preferably, the control unit 120 may be configured to select a battery module B of which the calculated internal resistance is equal to or less than the first criterion resistance R1 as the target module among the plurality of battery modules B.

The first criterion resistance R1 may employ a median value or an average value of the plurality of battery modules B. If the first criterion resistance R1 is an average value of the internal resistances of the plurality of battery modules B, a battery module B of which the internal resistance is equal to or less than the average may be selected as the target module. Conversely, if the first criterion resistance R1 is a median value of the internal resistances of the plurality of battery modules B, a battery module B of which the internal resistance belongs to lower 50% may be selected as the target module.

The control unit 120 is configured to calculate a second criterion resistance R2 for the target module based on the resistance information.

The second criterion resistance R2 is a value calculated by considering all the internal resistances of the plurality of target modules selected by the control unit 120, and may be a value representing the internal resistances of the plurality of target modules. That is, the second criterion resistance R2 may be a resistance value representing the internal resistances of the plurality of target modules, and the first criterion resistance R1 may be a resistance value representing the internal resistances of the plurality of battery modules B.

For example, the second criterion resistance R2 is a value representing the internal resistances of the plurality of target modules, and a median value or an average value may be applied. Preferably, the second criterion resistance R2 may be an average value of the internal resistances of a plurality of target modules.

The control unit 120 is configured to set a second resistance section based on the calculated second criterion resistance R2 and a connection structure between the battery cells included in each of the plurality of battery modules B.

Here, the connection structure between the battery cells means a series or parallel structure in which the plurality of battery cells included in each battery module B are connected to each other. In addition, the connection structure between the battery cells considered by the control unit 120 may be the number of parallel connection structures formed for the plurality of battery cells.

For example, it is assumed that a total of 16 battery cells are included in the battery module B, 8 battery cells are connected in series to form two unit modules, and the two unit modules are connected in parallel with each other. In this case, the control unit 120 may determine that the number of parallel connection structures between the plurality of battery cells included in the battery module B is two. Preferably, the plurality of battery modules B may be modules having the same connection structure of the included plurality of battery cells. That is, in the previous embodiment, all of the plurality of battery modules B may include 16 battery cells, the 16 battery cells may be connected in series by 8 battery cells to form two unit modules, and the formed two unit modules may be connected in parallel to each other.

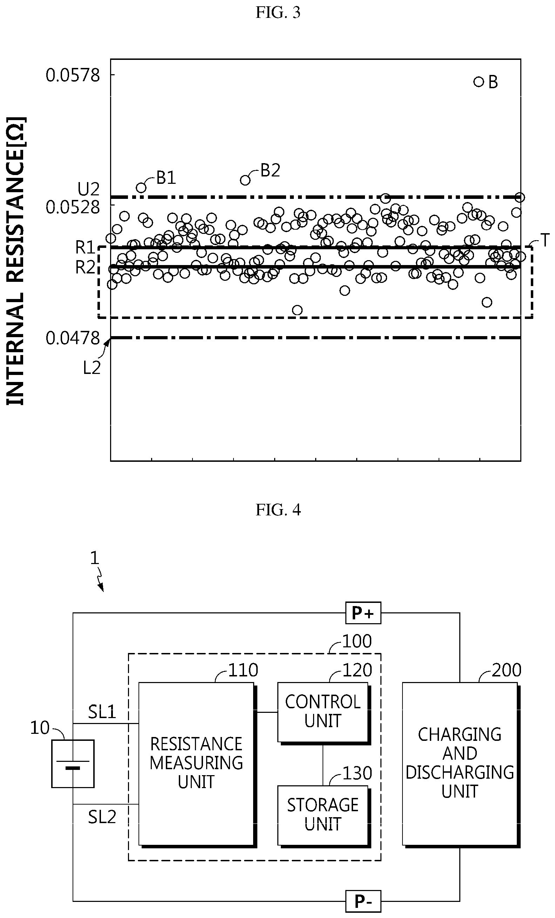

FIG. 3 is a diagram schematically showing the second resistance section according to an embodiment of the present disclosure. Specifically, FIG. 3 is a diagram showing the internal resistances of the plurality of battery modules B in the form of a graph, and includes a second criterion resistance R2, a second upper limit value U2, and a second lower limit value L2. Similar to FIG. 2, in FIG. 3, the Y-axis represents the internal resistance [Ω], and the X-axis may be a serial number of the battery module B. That is, the value of the X-axis is a value independent of the internal resistance, and may be applied without limitation as long as it is a factor that can identify each of the plurality of battery modules B. Specifically, in the embodiments of FIGS. 2 and 3, the plurality of battery modules B depicted may be the same.

Referring to FIG. 3, the second lower limit value L2 and the second upper limit value U2 may be set symmetrically with respect to the second criterion resistance R2. A resistance section from the second lower limit value L2 to the second upper limit value U2 may be set as the second resistance section. In addition, in the embodiment of FIG. 3, all of the internal resistances of the plurality of battery modules B may be included in the first resistance section.

The control unit 120 is configured to diagnose the state of each of the plurality of battery modules B based on the measured internal resistance, the first resistance section and the second resistance section.

The control unit 120 may diagnose the state of the plurality of battery modules B by considering both the first resistance section and the second resistance section, instead of considering only one of the first resistance section and the second resistance section.

Preferably, the control unit 120 may be configured to diagnose the state of a battery module B of which the calculated internal resistance belongs to both the first resistance section and the second resistance section as a normal state, among the plurality of battery modules B. Conversely, the control unit 120 may be configured to diagnose the state of a battery module B of which the calculated internal resistance does not belong to the first resistance section or the second resistance section as an abnormal state, among the plurality of battery modules B.

For example, referring to the embodiment of FIG. 2, the measured internal resistances of the first battery module B1 and the second battery module B2 among the plurality of battery modules B may be included in the first resistance section. hat is, the measured internal resistances of the first battery module B1 and the second battery module B2 may be greater than the first criterion resistance R1, but may be less than the first upper limit value U1.

However, referring to the embodiment of FIG. 3, the measured internal resistances of the first battery module B1 and the second battery module B2 among the plurality of battery modules B may not be included in the second resistance section. That is, the measured internal resistances of the first battery module B1 and the second battery module B2 may be greater than the second criterion resistance R2 and greater than the second upper limit value U2.

Accordingly, the control unit 120 may diagnose the states of the first battery module B1 and the second battery module B2 as an abnormal state.

That is, the first resistance section may be a resistance section set for the plurality of battery modules B, but the second resistance section may be a resistance section set for the plurality of target modules T. Accordingly, the first resistance section and the second resistance section may be different from each other. Since the battery diagnosing apparatus 100 diagnoses the state of the battery module B according to whether the measured internal resistance belongs to the first resistance section and the second resistance section, it is possible to diagnose the state of the battery module B with a stricter standard. In addition, since the battery diagnosing apparatus 100 diagnoses the state of the battery module B based on two independent resistance sections, there is an advantage in that the diagnosis accuracy for the state of the battery diagnosed by the battery diagnosing apparatus 100 may be improved.

In addition, the battery diagnosing apparatus 100 may store the information about the battery module B diagnosed as an abnormal state or output the information to the outside. Accordingly, the battery module B diagnosed as an abnormal state may be replaced and/or inspected precisely. That is, accidents such as explosions and fires that may occur due to continuous use of the battery module B in an abnormal state may be prevented in advance.

Meanwhile, the control unit 120 provided to the battery diagnosing apparatus 100 may optionally include a processor, an application-specific integrated circuit (ASIC), another chipset, a logic circuit, a register, a communication modem, and a data processing device, and the like, known in the art to execute various control logics performed in the present disclosure. In addition, when the control logic is implemented in software, the control unit 120 may be implemented as a set of program modules. At this time, the program module may be stored in a memory and executed by the control unit 120. The memory may be provided in or out of the control unit 120, and may be connected to the control unit 120 by various well-known means.

In addition, the battery diagnosing apparatus 100 may further include a storage unit 130. The storage unit 130 may store data or programs necessary for operation and function of each component of the battery diagnosing apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the storage unit 130 may store the resistance information of the plurality of battery modules B measured by the resistance measuring unit 110. The control unit 120 may directly receive the resistance information from the resistance measuring unit 110 or access the storage unit 130 to acquire the stored resistance information.

Hereinafter, the content of the control unit 120 setting the first resistance section will be described in detail.

The control unit 120 may be configured to calculate the first criterion resistance R1 based on the internal resistances of the plurality of battery modules B.

For example, the control unit 120 may calculate a median value for the internal resistances of the plurality of battery modules B measured by the resistance measuring unit 110. In addition, the control unit 120 may set the calculated median value as the first criterion resistance R1 for the plurality of battery modules B. That is, when the internal resistances of the plurality of battery modules B is arranged in order of magnitude, the control unit 120 may set a value located at the central as the first criterion resistance R1.

The control unit 120 may be configured to calculate the resistance deviation according to a difference between the calculated first criterion resistance R1 and the internal resistance of each of the plurality of battery modules B.

Specifically, the control unit 120 may calculate an absolute deviation between the calculated first criterion resistance R1 and the internal resistance of each of the plurality of battery modules B. More specifically, the control unit 120 may calculate a median absolute deviation (MAD) between the first criterion resistance R1 and the internal resistance of each of the plurality of battery modules.

For example, the control unit 120 may calculate the median absolute deviation between the first criterion resistance R1 and the internal resistance of each of the plurality of battery modules B using Equation 2 below. [Equation 2] $D = median \left(\left|{DCIR}_{i}-R1\right|\right) , \left(1\leq i\leq n\right)$

Here, i is an index indicating each battery module B, and may be 1 or more and n or less. n may be the total number of the plurality of battery modules B whose state is to be diagnosed by the battery diagnosing apparatus 100. R1 is the first criterion resistance, and DCIRᵢ is the internal resistance of the i^{th} battery module B. median () is a function that outputs a median value for |DCIRᵢ-R1|, and D may be a median absolute deviation (hereinafter, described as absolute deviation). That is, D may be the absolute deviation between the first criterion resistance R1 and the internal resistance (DCIRᵢ) of the plurality of battery modules B.

After calculating the absolute deviation (Dᵢ) for each of the plurality of battery modules B, the control unit 120 may convert the calculated absolute deviation (Dᵢ) into a resistance deviation (S).

Specifically, the control unit 120 may be configured to convert the calculated absolute deviation into the resistance deviation by using a predetermined scale factor.

For example, the control unit 120 may calculate the scale factor using Equation 3 below. [Equation 3] $C = - \frac{1}{\sqrt{2} \times erfcinv \left(a\right)}$

Here, C is the scale factor, erfcinv(a) is an inverse complementary error function, and a is a constant. For example, when a is 3/2, erfcinv(3/2) may be an output value of an inverse complementary error function with respect to the input value of 3/2.

The control unit 120 may convert the absolute deviation into a resistance deviation by using Equation 4 below. [Equation 4] $S = D \times C$

Here, S is the converted resistance deviation, D is the absolute deviation for the first criterion resistance R1 and the internal resistance of the plurality of battery modules B according to Equation 2, and C is the scale factor according to Equation 3.

The control unit 120 calculates the first lower limit value L1 by subtracting the resistance deviation from the first criterion resistance R1.

The control unit 120 calculates the first lower limit value L1 by subtracting the resistance deviation from the first criterion resistance R1. Specifically, in the embodiment of FIG. 2, the control unit 120 may calculate the first lower limit value L1 by subtracting the resistance deviation S according to Equation 4 from the first criterion resistance R1. That is, the control unit 120 may calculate "R1-S" to calculate the first lower limit value L1.

In addition, the control unit 120 is configured to calculate the first upper limit value U1 by adding the resistance deviation to the first criterion resistance R1.

For example, the control unit 120 may calculate the first upper limit value U1 by adding the resistance deviation to the first criterion resistance R1. Specifically, in the embodiment of FIG. 2, the control unit 120 may calculate the first upper limit value U1 by adding the resistance deviation S according to Equation 4 to the first criterion resistance R1. That is, the control unit 120 may calculate "R1+S" to calculate the first upper limit value U1.

Finally, the control unit 120 may be configured to set the first resistance section based on the calculated first lower limit value L1 and the calculated first upper limit value U1.

For example, the control unit 120 may set the calculated first lower limit value L1 as the lower limit threshold value of the first resistance section, and set the calculated first upper limit value U1 as the upper limit threshold value of the first resistance section. That is, the control unit 120 may set the resistance section corresponding to "R1-S to R1+S" as the first resistance section.

Hereinafter, the content of the control unit 120 setting the second resistance section will be described in detail.

The control unit 120 is configured to calculate a parallel deviation based on the number of parallel connections of the battery cells included in each of the plurality of battery modules B.

Here, the parallel deviation is the number of parallel connections of the plurality of battery cells included in the battery module B. For example, it is assumed that 16 battery cells are included in the battery module B, 8 battery cells are connected in series to form two unit modules, and two unit modules are connected in parallel with each other. In this case, the number of parallel connections for the battery module B calculated by the control unit 120 may be 2.

Thereafter, the control unit 120 may calculate a parallel coefficient from the number of parallel connections, and calculate a parallel deviation based on the calculated parallel coefficient and the second criterion resistance R2.

Specifically, the control unit 120 may be configured to calculate the parallel coefficient for the plurality of battery modules B based on the number of parallel connections.

Here, the parallel coefficient is a value related to the number of parallel connections of the plurality of battery cells included in the battery module B, and may be calculated according to Equation 5 below. [Equation 5] $μ = \frac{1}{m - b}$

Here, µ is the parallel coefficient, and m is the number of parallel connections. b is a constant, and for example, may be 0 or 1. That is, the parallel coefficient (µ) may be related to the reciprocal of the number of parallel connections (m).

In addition, the control unit 120 may be configured to calculate the parallel deviation by multiplying the calculated parallel coefficient by the second criterion resistance R2. For example, the control unit 120 may calculate the parallel deviation according to Equation 6 below. [Equation 6] $P = R 2 \times μ$

Here, P is the parallel deviation, R2 is the second criterion resistance, and µ is the parallel coefficient according to Equation 5.

The control unit 120 is configured to set the second resistance section according to the second criterion resistance R2 and the calculated parallel deviation.

The control unit 120 is configured to calculate the second lower limit value L2 by subtracting the parallel deviation from the second criterion resistance R2.

The control unit 120 calculates the second lower limit value L2 by subtracting the parallel deviation from the second criterion resistance R2. Specifically, in the embodiment of FIG. 3, the control unit 120 may calculate the second lower limit value L2 by subtracting the parallel deviation P according to Equation 6 from the second criterion resistance R2. That is, the control unit 120 may calculate "R2-P" to calculate the second lower limit value L2.

Also, the control unit 120 is configured to calculate the second upper limit value U2 by adding the parallel deviation to the second criterion resistance R2.

The control unit 120 calculates the second upper limit value U2 by adding the parallel deviation to the second criterion resistance R2. Specifically, in the embodiment of FIG. 3, the control unit 120 may calculate the second upper limit value U2 by adding the parallel deviation P according to Equation 6 to the second criterion resistance R2. That is, the control unit 120 may calculate "R2+P" to calculate the second upper limit value U2.

Finally, the control unit 120 may be configured to set the second resistance section based on the calculated second lower limit value L2 and the calculated second upper limit value U2.

For example, the control unit 120 may set the calculated second lower limit value L2 as the lower limit threshold value of the second resistance section, and set the calculated second upper limit value U2 as the upper limit threshold value of the second resistance section. That is, the control unit 120 may set the resistance section corresponding to "R2-P to R2+P" as the second resistance section.

The battery diagnosing apparatus 100 according to the present disclosure may be applied to a BMS (Battery Management System). That is, the BMS according to the present disclosure may include the battery diagnosing apparatus 100 described above. In this configuration, at least some components of the battery diagnosing apparatus 100 may be implemented by supplementing or adding functions of the configuration included in the conventional BMS. For example, the resistance measuring unit 110, the control unit 120 and the storage unit 130 may be implemented as components of the BMS.

In addition, the battery diagnosing apparatus 100 according to the present disclosure may be provided to a battery pack 1. That is, the battery pack 1 according to the present disclosure may include the above-described battery diagnosing apparatus 100 and at least one battery module B. In addition, the battery pack 1 may further include electrical equipment (a relay, a fuse, etc.) and a case.

FIG. 4 is a diagram schematically showing an exemplary configuration of a battery pack 1 according to another embodiment of the present disclosure.

Referring to FIG. 4, the battery pack 1 may include a battery 10 and a battery diagnosing apparatus 100. In addition, a charging and discharging unit 200 may be included in the battery pack 1 or may be provided outside the battery pack 1 and connected to a positive electrode terminal P+ and a negative electrode terminal P- of the battery pack 1.

In the embodiment of FIG. 4, the battery 10 may include a plurality of battery modules B. In addition, each battery module B may include a plurality of battery cells having the same connection structure. That is, the parallel coefficient (parallel coefficient (µ) according to Equation 5) for the plurality of battery modules B may be the same.

In the embodiment of FIG. 4, the resistance measuring unit 110 may measure the resistance of the battery 10 when charging of the battery 10 is started or the discharging is terminated by the charging and discharging unit 200. Specifically, the resistance measuring unit 110 may be connected to the battery 10 through a first sensing line SL1 and a second sensing line SL2. The resistance measuring unit 110 may measure the voltage of the battery 10 based on the voltage value measured at each of the first sensing line SL1 and the second sensing line SL2. In addition, the resistance measuring unit 110 may measure the internal resistance of the battery 10 based on Equation 1. Preferably, the resistance measuring unit 110 may measure the internal resistance of each of the plurality of battery modules B included in the battery 10.

In addition, the control unit 120 may diagnose the state of each of the plurality of battery modules B based on the resistance information for the plurality of battery modules B measured by the resistance measuring unit 110.

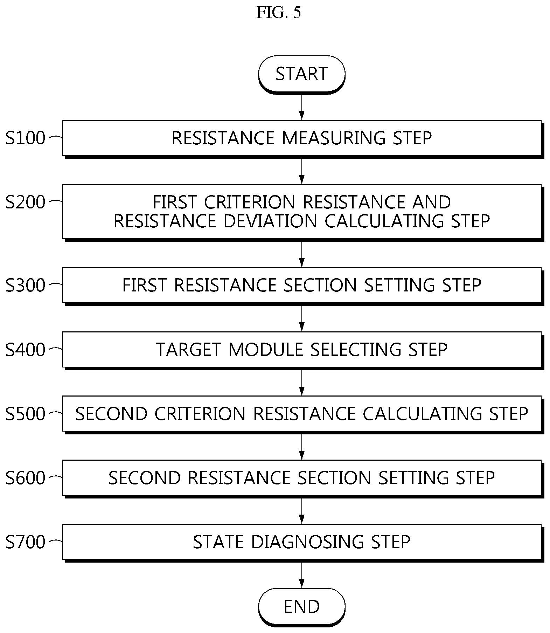

FIG. 5 is a diagram schematically showing a battery diagnosing method according to still another embodiment of the present disclosure.

Hereinafter, for convenience of description, it should be noted that the content overlapping with the previously described content will be omitted or briefly described.

Preferably, each step of the battery diagnosing method may be performed by the battery diagnosing apparatus 100. Referring to FIG. 5, the battery diagnosing method includes a resistance measuring step (S100), a first criterion resistance and resistance deviation calculating step (S200), a first resistance section setting step (S300), a target module T selecting step (S400), a second criterion resistance calculating step (S500), a second resistance section setting step (S600) and a state diagnosing step (S700).

The resistance measuring step (S100) is a step of measuring an internal resistance of each of a plurality of battery modules B including one or more battery cells, and may be performed by the resistance measuring unit 110.

For example, the resistance measuring unit 110 may measure the resistance of each of the plurality of battery modules B when the charging of the battery module B is started or the discharging is terminated. Preferably, the resistance measuring unit 110 may measure the voltage of each of the plurality of battery modules B at two different time points, and may measure the resistance of each of the plurality of battery modules B based on Equation 1.

The first criterion resistance and resistance deviation calculating step (S200) is a step of calculating a first criterion resistance R1 and a resistance deviation for the plurality of battery modules B based on the resistance information about the internal resistance of each of the plurality of battery modules B measured in the resistance measuring step (S100), and may be performed by the control unit 120.

For example, the control unit 120 may calculate a value representing the internal resistance of each of the plurality of battery modules B measured by the resistance measuring unit 110 as the first criterion resistance R1. Here, the control unit 120 may calculate an average value or a median value of the internal resistances of the plurality of battery modules B as the first criterion resistance R1.

In addition, the control unit 120 may calculate an absolute deviation D according to Equation 2, calculate a scale factor C according to Equation 3, and calculate a resistance deviation S according to Equation 5.

The first resistance section setting step (S300) is a step of setting a first resistance section based on the first criterion resistance R1 and the resistance deviation calculated in the first criterion resistance and resistance deviation calculating step (S200), and may be performed by the control unit 120.

The control unit 120 calculates a first upper limit value U1 by adding resistance deviation S to the first criterion resistance R1, and calculates a first lower limit value L1 by subtracting the resistance deviation S from the first criterion resistance R1. In addition, the control unit 120 may set a resistance section for the first lower limit value L1 to the first upper limit value U1 as the first resistance section.

The target module T selecting step (S400) is a step of selecting a part of the plurality of battery modules B as a target module T based on the resistance information, and may be performed by the control unit 120.

For example, the control unit 120 may select a battery module B having an internal resistance equal to or less than the first criterion resistance R1 among the plurality of battery modules B as the target module T.

The second criterion resistance calculating step (S500) is a step of calculating a second criterion resistance R2 for the target module T based on the resistance information, and may be performed by the control unit 120.

For example, the control unit 120 may calculate a value representing the internal resistance of each of the plurality of target modules T as the second criterion resistance R2. Here, the control unit 120 may calculate an average value or a median value of the internal resistances of the plurality of target modules T as the second criterion resistance R2.

Preferably, the control unit 120 may set the calculation condition for the first criterion resistance R1 and the calculation condition for the second criterion resistance R2 differently. For example, when the first criterion resistance R1 is calculated as a median value of the internal resistances of the plurality of battery modules B, the second criterion resistance R2 may be calculated as an average value of the internal resistances of the plurality of target modules T.

The second resistance section setting step (S600) is a step of setting a second resistance section based on the second criterion resistance R2 calculated in the second criterion resistance calculating step (S500) and the connection structure between the battery cells included in each of the plurality of battery modules B, and may be performed by the control unit 120.

For example, the control unit 120 may calculate a parallel coefficient (µ) according to Equation 5 in consideration of the connection structure of the plurality of battery cells included in the battery module B. In addition, the control unit 120 may calculate the parallel deviation P according to Equation 6.

The state diagnosing step (S700) is a step of diagnosing the state of each of the plurality of battery modules B based on the measured internal resistance, the first resistance section and the second resistance section, and may be performed by the control unit 120.

For example, the control unit 120 may diagnose the state of the battery module B of which the calculated internal resistance belongs to both the first resistance section and the second resistance section as a normal state among the plurality of battery modules B. Conversely, the control unit 120 may diagnose the state of the battery module B of which the calculated internal resistance does not belong to the first resistance section or the second resistance section as an abnormal state among the plurality of battery modules B.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the appended claims will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications within the scope of the appended claims.

### (Reference Signs)

1: battery pack
10: battery
100: battery diagnosing apparatus
110: resistance measuring unit
120: control unit
130: storage unit
200: charging and discharging unit

## Claims

1. A battery diagnosing apparatus (100), comprising:
a resistance measuring unit (110) configured to measure an internal resistance of each of a plurality of battery modules including one or more battery cells; and
a control unit (120) configured to receive resistance information about the internal resistance of each of the plurality of battery modules (B) from the resistance measuring unit, calculate a first criterion resistance (R1) and a resistance deviation (S) for the plurality of battery modules based on the resistance information, set a first resistance section by adding or subtracting the calculated resistance deviation from the first criterion resistance (R1), select a part of the plurality of battery modules as a target module based on the resistance information, calculate a second criterion resistance (R2) for the target module based on the resistance information, set a second resistance section by adding or subtracting a parallel deviation corresponding to a connection structure between the battery cells included in each of the plurality of battery modules from the second criterion resistance (R2), and diagnose a state of each of the plurality of battery modules based on the measured internal resistance, the first resistance section and the second resistance section; wherein the control unit is configured to calculate the parallel deviation based on the number of parallel connections of the battery cells included in each of the plurality of battery modules.

2. The battery diagnosing apparatus according to claim 1,
wherein the control unit is configured to diagnose a state of a battery module of which the calculated internal resistance belongs to both the first resistance section and the second resistance section as a normal state among the plurality of battery modules, and
wherein the control unit is configured to diagnose a state of a battery module of which the calculated internal resistance does not belong to the first resistance section or the second resistance section as an abnormal state among the plurality of battery modules.

3. The battery diagnosing apparatus according to claim 1,
wherein the control unit is configured to calculate the first criterion resistance based on the internal resistances of the plurality of battery modules, and calculate the resistance deviation based on a difference between the calculated first criterion resistance and the internal resistance of each of the plurality of battery modules.

4. The battery diagnosing apparatus according to claim 3,
wherein the control unit is configured to calculate a first lower limit value (L1) by subtracting the resistance deviation from the first criterion resistance, calculate a first upper limit value (U1) by adding the resistance deviation to the first criterion resistance, and set the first resistance section based on the calculated first lower limit value and the calculated first upper limit value.

5. The battery diagnosing apparatus according to claim 3,
wherein the control unit is configured to calculate an absolute deviation between the calculated first criterion resistance and the internal resistance of each of the plurality of battery modules, and convert the calculated absolute deviation into the resistance deviation by using a predetermined scale factor.

6. The battery diagnosing apparatus according to claim 5,
wherein the first criterion resistance is a median value for the internal resistances of the plurality of battery modules.

7. The battery diagnosing apparatus according to claim 1,
wherein the control unit is configured to select a battery module of which the calculated internal resistance is equal to or less than the first criterion resistance as the target module among the plurality of battery modules.

8. The battery diagnosing apparatus according to claim 1,
wherein the control unit is configured to calculate a second lower limit value (L2) by subtracting the parallel deviation from the second criterion resistance, calculate a second upper limit value (U2) by adding the parallel deviation to the second criterion resistance, and set the second resistance section based on the calculated second lower limit value and the calculated second upper limit value.

9. The battery diagnosing apparatus according to claim 1,
wherein the control unit is configured to calculate a parallel coefficient for the plurality of battery modules based on the number of parallel connections, and calculate the parallel deviation by multiplying the calculated parallel coefficient by the second criterion resistance.

10. The battery diagnosing apparatus according to claim 9,
wherein the second criterion resistance is an average value for the internal resistance of the target module.

11. A battery pack (1), comprising the battery diagnosing apparatus (100) according to any one of claims 1 to 10.

12. A battery diagnosing method, comprising:
a resistance measuring step (S100) of measuring an internal resistance of each of a plurality of battery modules including one or more battery cells;
a first criterion resistance and resistance deviation calculating step (S200) of calculating a first criterion resistance (R1) and a resistance deviation for the plurality of battery modules based on resistance information about the internal resistance of each of the plurality of battery modules measured in the resistance measuring step;
a first resistance section setting step (S300) of setting a first resistance section by adding or subtracting the calculated resistance deviation from the first criterion resistance;
a target module selecting step (S400) of selecting a part of the plurality of battery modules as a target module based on the resistance information;
a second criterion resistance calculating step (S500) of calculating a second criterion resistance for the target module based on the resistance information;
a second resistance section setting step (S600) of setting a second resistance section by adding or subtracting a parallel deviation corresponding to a connection structure between the battery cells included in each of the plurality of battery modules from the second criterion resistance; and
a state diagnosing step (S700) of diagnosing a state of each of the plurality of battery modules based on the measured internal resistance, the first resistance section and the second resistance section;
wherein the parallel deviation is based on the number of parallel connections of the battery cells included in each of the plurality of battery modules.

## Patentansprüche

1. Batteriediagnosevorrichtung (100), umfassend:
eine Widerstandsmessungseinheit (110), die konfiguriert ist, um einen Innenwiderstand von jedem einer Vielzahl von Batteriemodulen, die eine oder mehrere Batteriezellen enthalten, zu messen; und
eine Steuereinheit (120), die konfiguriert ist, um Widerstandsinformationen über den Innenwiderstand von jedem der Vielzahl von Batteriemodulen (B) von der Widerstandsmessungseinheit zu empfangen, einen ersten Kriteriumswiderstand (R1) und eine Widerstandsabweichung (S) für die Vielzahl von Batteriemodulen basierend auf den Widerstandsinformationen zu berechnen, einen ersten Widerstandsbereich durch Addieren oder Subtrahieren der berechneten Widerstandsabweichung vom ersten Kriteriumswiderstand (R1) festzulegen, einen Teil der Vielzahl von Batteriemodulen als Zielmodul basierend auf den Widerstandsinformationen auszuwählen, einen zweiten Kriteriumswiderstand (R2) für das Zielmodul basierend auf den Widerstandsinformationen zu berechnen, einen zweiten Widerstandsbereich durch Addieren oder Subtrahieren einer Parallelabweichung, die einer Verbindungsstruktur zwischen den Batteriezellen entspricht, die in jedem der Vielzahl von Batteriemodulen enthalten sind, vom zweiten Kriteriumswiderstand (R2) festzulegen, und einen Zustand von jedem der Vielzahl von Batteriemodulen basierend auf dem gemessenen Innenwiderstand, dem ersten Widerstandsbereich und dem zweiten Widerstandsbereich zu diagnostizieren; wobei die Steuereinheit konfiguriert ist, um die Parallelabweichung basierend auf der Anzahl von Parallelschaltungen der Batteriezellen, die in jedem der Vielzahl von Batteriemodulen enthalten sind, zu berechnen.

2. Batteriediagnosevorrichtung nach Anspruch 1,
wobei die Steuereinheit konfiguriert ist, um einen Zustand eines Batteriemoduls, dessen berechneter Innenwiderstand sowohl zu dem ersten Widerstandsbereich als auch zu dem zweiten Widerstandsbereich gehört, als einen Normalzustand unter der Vielzahl von Batteriemodulen zu diagnostizieren, und
wobei die Steuereinheit konfiguriert ist, um einen Zustand eines Batteriemoduls, dessen berechneter Innenwiderstand nicht zu dem ersten Widerstandsbereich oder zu dem zweiten Widerstandsbereich gehört, als einen anomalen Zustand unter der Vielzahl von Batteriemodulen zu diagnostizieren.

3. Batteriediagnosevorrichtung nach Anspruch 1,
wobei die Steuereinheit konfiguriert ist, um den ersten Kriteriumswiderstand basierend auf den Innenwiderständen der Vielzahl von Batteriemodulen zu berechnen und die Widerstandsabweichung basierend auf einer Differenz zwischen dem berechneten ersten Kriteriumswiderstand und dem Innenwiderstand von jedem der Vielzahl von Batteriemodulen zu berechnen.

4. Batteriediagnosevorrichtung nach Anspruch 3,
wobei die Steuereinheit konfiguriert ist, um einen ersten unteren Grenzwert (L1) durch Subtrahieren der Widerstandsabweichung vom ersten Kriteriumswiderstand zu berechnen, einen ersten oberen Grenzwert (U1) durch Addieren der Widerstandsabweichung zu dem ersten Kriteriumswiderstand zu berechnen und den ersten Widerstandsbereich basierend auf dem berechneten ersten unteren Grenzwert und dem berechneten ersten oberen Grenzwert festzulegen.

5. Batteriediagnosevorrichtung nach Anspruch 3,
wobei die Steuereinheit konfiguriert ist, um eine absolute Abweichung zwischen dem berechneten ersten Kriteriumswiderstand und dem Innenwiderstand von jedem der Vielzahl von Batteriemodulen zu berechnen und die berechnete absolute Abweichung unter Verwendung eines vorbestimmten Skalierungsfaktors in die Widerstandsabweichung umzuwandeln.

6. Batteriediagnosevorrichtung nach Anspruch 5,
wobei der erste Kriteriumswiderstand ein Medianwert für die Innenwiderstände der Vielzahl von Batteriemodulen ist.

7. Batteriediagnosevorrichtung nach Anspruch 1,
wobei die Steuereinheit konfiguriert ist, um ein Batteriemodul, dessen berechneter Innenwiderstand gleich dem oder kleiner als der erste Kriteriumswiderstand ist, als das Zielmodul aus der Vielzahl von Batteriemodulen auszuwählen.

8. Batteriediagnosevorrichtung nach Anspruch 1,
wobei die Steuereinheit konfiguriert ist, um einen zweiten unteren Grenzwert (L2) durch Subtrahieren der Parallelabweichung vom zweiten Kriteriumswiderstand zu berechnen, einen zweiten oberen Grenzwert (U2) durch Addieren der Parallelabweichung zu dem zweiten Kriteriumswiderstand zu berechnen und den zweiten Widerstandsbereich basierend auf dem berechneten zweiten unteren Grenzwert und dem berechneten zweiten oberen Grenzwert festzulegen.

9. Batteriediagnosevorrichtung nach Anspruch 1,
wobei die Steuereinheit konfiguriert ist, um einen Parallelkoeffizienten für die Vielzahl von Batteriemodulen basierend auf der Anzahl von Parallelschaltungen zu berechnen und die Parallelabweichung durch Multiplizieren des berechneten Parallelkoeffizienten mit dem zweiten Kriteriumswiderstand zu berechnen.

10. Batteriediagnosevorrichtung nach Anspruch 9,
wobei der zweite Kriteriumswiderstand ein Durchschnittswert für den Innenwiderstand des Zielmoduls ist.

11. Batteriepack (1), umfassend die Batteriediagnosevorrichtung (100) nach einem der Ansprüche 1 bis 10.

12. Batteriediagnoseverfahren, umfassend:
einen Widerstandsmessungsschritt (S100) des Messens eines Innenwiderstands von jedem einer Vielzahl von Batteriemodulen, die eine oder mehrere Batteriezellen enthalten;
einen Berechnungsschritt (S200) für einen ersten Kriteriumswiderstand und eine Widerstandsabweichung des Berechnens eines ersten Kriteriumswiderstands (R1) und einer Widerstandsabweichung für die Vielzahl von Batteriemodulen basierend auf Widerstandsinformationen über den Innenwiderstand von jedem der Vielzahl von Batteriemodulen, der im Widerstandsmessungsschritt gemessen wurde;
einen Einstellschritt (S300) für einen ersten Widerstandsbereich des Festlegens eines ersten Widerstandsbereiches durch Addieren oder Subtrahieren der berechneten Widerstandsabweichung vom ersten Kriteriumswiderstand;
einen Auswahlschritt (S400) für ein Zielmodul des Auswählens eines Teils der Vielzahl von Batteriemodulen als Zielmodul basierend auf den Widerstandsinformationen;
einen Berechnungsschritt (S500) für einen zweiten Kriteriumswiderstand des Berechnens eines zweiten Kriteriumswiderstands für das Zielmodul basierend auf den Widerstandsinformationen;
einen Einstellschritt (S600) für einen zweiten Widerstandsbereich des Festlegens eines zweiten Widerstandsbereiches durch Addieren oder Subtrahieren einer Parallelabweichung, die einer Verbindungsstruktur zwischen den Batteriezellen entspricht, die in jedem der Vielzahl von Batteriemodulen enthalten sind, vom zweiten Kriteriumswiderstand; und
einen Zustandsdiagnoseschritt (S700) des Diagnostizierens eines Zustands von jedem der Vielzahl von Batteriemodulen basierend auf dem gemessenen Innenwiderstand, dem ersten Widerstandsbereich und dem zweiten Widerstandsbereich;
wobei die Parallelabweichung auf der Anzahl von Parallelschaltungen der Batteriezellen basiert, die in jedem der Vielzahl von Batteriemodulen enthalten sind.

## Revendications

1. Appareil de diagnostic de batterie (100), comprenant :
une unité de mesure de résistance (110) configurée pour mesurer une résistance interne de chacun d'une pluralité de modules de batterie incluant une ou plusieurs cellules de batterie ; et
une unité de commande (120) configurée pour recevoir des informations de résistance concernant la résistance interne de chacun de la pluralité de modules de batterie (B) depuis l'unité de mesure de résistance, calculer une première résistance de critère (R1) et un écart de résistance (S) pour la pluralité de modules de batterie sur la base des informations de résistance, définir une première section de résistance en ajoutant ou en soustrayant l'écart de résistance calculé de la première résistance de critère (R1), sélectionner une partie de la pluralité de modules de batterie en tant que module cible sur la base des informations de résistance, calculer une seconde résistance de critère (R2) pour le module cible sur la base des informations de résistance, définir une seconde section de résistance en ajoutant ou en soustrayant un écart parallèle correspondant à une structure de connexion entre les cellules de batterie incluses dans chacun de la pluralité de modules de batterie de la seconde résistance de critère (R2), et diagnostiquer un état de chacun de la pluralité de modules de batterie sur la base de la résistance interne mesurée, de la première section de résistance et de la seconde section de résistance ; dans lequel l'unité de commande est configurée pour calculer l'écart parallèle sur la base du nombre de connexions en parallèle des cellules de batterie incluses dans chacun de la pluralité de modules de batterie.

2. Appareil de diagnostic de batterie selon la revendication 1,
dans lequel l'unité de commande est configurée pour diagnostiquer un état d'un module de batterie dont la résistance interne calculée appartient à la fois à la première section de résistance et à la seconde section de résistance comme un état normal parmi la pluralité de modules de batterie, et
dans lequel l'unité de commande est configurée pour diagnostiquer un état d'un module de batterie dont la résistance interne calculée n'appartient pas à la première section de résistance ou à la seconde section de résistance comme un état anormal parmi la pluralité de modules de batterie.

3. Appareil de diagnostic de batterie selon la revendication 1,
dans lequel l'unité de commande est configurée pour calculer la première résistance de critère sur la base des résistances internes de la pluralité de modules de batterie, et calculer l'écart de résistance sur la base d'une différence entre la première résistance de critère calculée et la résistance interne de chacun de la pluralité de modules de batterie.

4. Appareil de diagnostic de batterie selon la revendication 3,
dans lequel l'unité de commande est configurée pour calculer une première valeur limite inférieure (L1) en soustrayant l'écart de résistance de la première résistance de critère, calculer une première valeur limite supérieure (U1) en ajoutant l'écart de résistance à la première résistance de critère, et définir la première section de résistance sur la base de la première valeur limite inférieure calculée et de la première valeur limite supérieure calculée.

5. Appareil de diagnostic de batterie selon la revendication 3,
dans lequel l'unité de commande est configurée pour calculer un écart absolu entre la première résistance de critère calculée et la résistance interne de chacun de la pluralité de modules de batterie, et convertir l'écart absolu calculé en écart de résistance en utilisant un facteur d'échelle prédéterminé.

6. Appareil de diagnostic de batterie selon la revendication 5,
dans lequel la première résistance de critère est une valeur médiane pour les résistances internes de la pluralité de modules de batterie.

7. Appareil de diagnostic de batterie selon la revendication 1,
dans lequel l'unité de commande est configurée pour sélectionner un module de batterie dont la résistance interne calculée est égale ou inférieure à la première résistance de critère en tant que module cible parmi la pluralité de modules de batterie.

8. Appareil de diagnostic de batterie selon la revendication 1,
dans lequel l'unité de commande est configurée pour calculer une seconde valeur limite inférieure (L2) en soustrayant l'écart parallèle de la seconde résistance de critère, calculer une seconde valeur limite supérieure (U2) en ajoutant l'écart parallèle à la seconde résistance de critère, et définir la seconde section de résistance sur la base de la seconde valeur limite inférieure calculée et de la seconde valeur limite supérieure calculée.

9. Appareil de diagnostic de batterie selon la revendication 1,
dans lequel l'unité de commande est configurée pour calculer un coefficient parallèle pour la pluralité de modules de batterie sur la base du nombre de connexions en parallèle, et calculer l'écart parallèle en multipliant le coefficient parallèle calculé par la seconde résistance de critère.

10. Appareil de diagnostic de batterie selon la revendication 9,
dans lequel la seconde résistance de critère est une valeur moyenne pour la résistance interne du module cible.

11. Bloc de batteries (1), comprenant l'appareil de diagnostic de batterie (100) selon l'une quelconque des revendications 1 à 10.

12. Procédé de diagnostic de batterie, comprenant :
une étape de mesure de résistance (S100) consistant à mesurer une résistance interne de chacun d'une pluralité de modules de batterie incluant une ou plusieurs cellules de batterie ;
une étape de calcul de première résistance de critère et d'écart de résistance (S200) consistant à calculer une première résistance de critère (R1) et un écart de résistance pour la pluralité de modules de batterie sur la base d'informations de résistance concernant la résistance interne de chacun de la pluralité de modules de batterie mesurée dans l'étape de mesure de résistance ;
une étape de définition de première section de résistance (S300) consistant à définir une première section de résistance en ajoutant ou en soustrayant l'écart de résistance calculé de la première résistance de critère ;
une étape de sélection de module cible (S400) consistant à sélectionner une partie de la pluralité de modules de batterie en tant que module cible sur la base des informations de résistance ;
une étape de calcul de seconde résistance de critère (S500) consistant à calculer une seconde résistance de critère pour le module cible sur la base des informations de résistance ;
une étape de définition de seconde section de résistance (S600) consistant à définir une seconde section de résistance en ajoutant ou en soustrayant un écart parallèle correspondant à une structure de connexion entre les cellules de batterie incluses dans chacun de la pluralité de modules de batterie de la seconde résistance de critère ; et
une étape de diagnostic d'état (S700) consistant à diagnostiquer un état de chacun de la pluralité de modules de batterie sur la base de la résistance interne mesurée, de la première section de résistance et de la seconde section de résistance ;
dans lequel l'écart parallèle est basé sur le nombre de connexions en parallèle des cellules de batterie incluses dans chacun de la pluralité de modules de batterie.
